# EUROPEAN PATENT SPECIFICATION

(11) **EP 1 837 383 B1**
(45) Date of publication and mention of the grant of the patent: **04.06.2008**
(21) Application number: 06004444.3
(22) Date of filing: 06.03.2006
(51) Int. Cl.: C09J 4/00, C08L 63/00, C09J 163/00, H05K 3/30, C08K 3/08

(54) **Die-attach composition for high power semiconductors**
Zusammensetzung zur Befestigung von Hochleistungshalbleiter
Composition pour fixation de semi-conducteurs à haute puissance

(43) Date of publication of application: 26.09.2007
(73) Proprietor: Umicore AG & Co. KG, 63457 Hanau-Wolfgang (DE)
(72) Inventor: Thomas, Muriel, 63128 Dietzenbach (DE); Schaack, Klaus, 63785 Obernburg (DE); Görgen, Timo, North Vancouver V7L 1T7 (CA)

(56) References cited:
- WO-A-20/04090942
- F F T DE ARAUJO AND H M ROSENBERG: "The thermal conductivity of epoxy -resin/met al-po w der composite materials from 1.7 to 300 K" JOURNAL OF PHYSICS D: APPLIED PHYSICS, vol. 9, 1976, pages 665-675, XP002383178
- ADALBERT LOSSIN: "Copper in Ullmann's Encyclopedia of Industrial Chemistry" 15 January 2001 (2001-01-15), WILEY-VCH , WEINHEIM , XP002383389 * page 1 - page 5 *

## Description

The present invention provides a lead-free adhesive composition for die-attachment of high power semiconductors.

According to the Directive 2002/95/EC of the European Parliament and of the Council, from 1^{st} July 2006 new electrical and electronic equipment put on the market must no longer contain lead and other hazardous substances. This directive has led to the development of lead-free solder alloys for various electrical and electronic applications. But there still exist some exemptions from the directive. Among others, lead in high melting temperature type solders (i.e. lead-based alloys containing 85 % by weight or more lead) do not have to be replaced due to lack of lead-free alternatives for these alloys. This exemption has just recently been confirmed by the Commission Decision 2005/747/EC of 21^{st} October 2005.

Lead-based solder alloys containing more than 85 % by weight of lead are up to now needed for so-called high-temperature applications with average operating temperatures of more than 150 °C and peak processing temperatures up to 260 °C. One prominent example are die-attach applications for power semiconductors. In these applications, the lead-based solder alloys provide sufficient resistance to thermal fatigue when subjecting the semiconductor devices to thermal cycling. In addition, these solders provide sufficient thermal conductivity for dissipating the heat generated by the power semiconductors.

According to Philip Adamson in "Lead-free Packaging for Discrete Power Semiconductors", a paper presented at the 2002 JEDEC Conference in Apr/May 2002, many small power packages already use a lead-free die-attach in the form of Ag-filled epoxy resins. These Ag-filled epoxy resins are loaded with up to 70 % silver. Their use, however, has not yet been expanded to larger silicon sizes in larger power packages. According to Adamson, Ag-filled expoxies have been tested by temperature cycling on larger components such as TO220. These experimental components were temperature cycled between -40 and +125 °C. These test conditions comply with condition "G" as specified by the JEDEC Standard JESD22-A 104C of May 2005.

The JEDEC Standard does not recommend test conditions that exceed +125 °C for Pb/Sn solder compositions. Nevertheless, the harsh operating conditions of power semiconductor devices require that they withstand test conditions specified by test condition "H" of the JEDEC Standard and require temperature cycling between -55 and +150 °C.

Although Directive 2002/95/EC exempts lead in high melting temperature type solders from being replaced with a lead-free alternative from 1^{st} July 2006 on, it would be very beneficial for the environment to replace high lead containing solders with a lead-free alternative for die-attach applications as soon as possible.

Araujo et. al. in J. Phys. D: Appl. Phys., Vol. 9, 1976, pages 665 to 675 have performed measurements of the thermal conductivity of epoxy resin/metal-powder composite materials from 1.7 to 300 K. WO 2004/090942 describes a thermally conductive adhesive composition and process for device attachment. The adhesive composition comprises two different types of metal powders, one being a powder of a high melting point metal and the other being a powder of a low melting point metal.

It is the object of this invention to provide a lead-free adhesive composition for die-attach applications of power semiconductors which reliably withstands temperature cycling according to JEDEC test condition "H" for at least 1000 cycles with a soak time of 15 minutes for maximum and minimum temperatures and exhibits thermal conductivity similar to the high lead containing solders presently in use. High thermal conductivity is mandatory for manufacturing power devices with high thermal power dissipation. It is a further object of the invention to provide formulations of the adhesive composition being suitable for different application methods such as dispensing or printing.

This objective is achieved by the die-attach composition specified in the claims. In particular, the die-attach composition according to the invention comprises a two component adhesive and a metal powder as filler, wherein one component of the adhesive is an epoxy resin and the second component is a curing agent and wherein the metal of the metal powder has a thermal conductivity of more than 250 W/(m · K) and comprises copper, and the powder particles have a spheroidal shape.

The cured die-attach composition has to have a similar thermal conductivity as the conventional high lead solders used for attaching high power semiconductor devices. Such high lead solder alloys are e.g. Pb88Sn10Ag2 with a thermal conductivity of 55 W/(m · K) and Pb92.5Sn5Ag2.5 with a thermal conductivity of 44 W/(m · K). It has been found that the cured die-attach composition with a thermal conductivity of more than 40 W/(m · K) complies with the need with respect to power dissipation from the power semiconductor as well as resistance to temperature cycling.

Thermal conductivity of the cured die-attach composition is a function of thermal conductivity of the filler material, thermal conductivity of the epoxy resin, the volume fraction of the filler material and of the thermal contact resistance between the filler and the epoxy resin.

The resulting thermal conductivity is of course mainly influenced by the filler which comprises copper. Thermal conductivity of pure copper is 400 W/(m · K), while the thermal conductivity of epoxy resin is as low as 0.3 W/(m · K). To guarantee a high thermal conductivity of the filler-epoxy composite thermal conductivity of the filler powder should be larger than 250, preferably larger than 300 and most preferred larger than 350 W/(m · K).

The thermal conductivity of the filler-epoxy composite is further dependent on the volume fraction of filler. In the following, the term filling degree will be used instead of volume fraction of filler. The filling degree is defined as the weight percentage of filler relative to the total weight of the composite. According to the invention the powder particles of the metal powder should have a spheroidal or spherical shape. Flake like powders give inferior results and moreover adhesives filled with flakes will block the syringe when using the die-attach composition in dispensing applications. In case of spheroidal filler particles the maximum volume fraction is obtained for a hexagonal close packing with a volume fraction of 74 %. This value translates into a maximum filling degree of 95 wt.-% for a copper powder as filler by using the density of copper (8.9 g/cm³) and of epoxy resin (approximately 1.2 g/cm³).

The mean particle size D₅₀ of the copper powder has no decisive influence on thermal fatigue resistance of the filler-epoxy composite. Good results have been obtained with filler powders having a mean particle diameter D₅₀ between 1 and 50 µm. More preferred are particle diameters between 1 and 30 µm.

At last, the resulting thermal conductivity of the filler-epoxy composite depends on the thermal contact resistance between the filler surface and the resin. Any impurity layer on the surface of the filler particles will increase the contact resistance. Therefore it is preferred to use filler powders with low surface impurities.

Due to its high thermal conductivity it is preferred to use metal powders comprising a high percentage of copper. Most preferred are copper powders with a purity of copper of more than 99.5 wt.-% and especially more than 99.9 wt.-%.

In case of copper powder, the most detrimental impurity on the surface of the powder particles is copper (II) oxide. The proportion of copper (II) oxide relative to metallic copper in a thin surface layer of approximately 5 nm thickness can be determined with XPS (X-Ray Photoelectron Spectroscopy). For that purpose the obtained XPS spectra are analyzed by curve fitting as is well known in the art. It has been found that good results with regard to thermal conductivity and thermal fatigue of the cured composite can be obtained if at most 50 % of the atoms in the surface layer analyzed by XPS are oxidized to CuO. Preferably the oxidized copper atoms should not exceed 30 % , more preferred not more than 10 %.

Relative to the thermal conductivity of metal powders the thermal conductivity of cured epoxy resin is very low. The main task of the epoxy resin is to provide good adhesion to the metal filler and to the semiconductor device and the substrate. Epoxy resins selected from the group consisting of bisphenol A epoxy resin and bisphenol F epoxy resin have proven to provide good adhesion to copper and nickel surfaces as well as to chips. Bisphenol F epoxy resin is most preferred. As curing agent a conventional mixture of imidazole, acrylonitrile and aliphatic amines can be used.

The cured die-attach composition comprising the cured adhesive filled with the specified filler powder and having a bond-line thickness between 20 and 80 µm withstands the above mentioned test conditions for thermal fatigue and has a similar thermal conductivity as high-lead solders.

The components of the die-attach composition can be used in different formulations:
- The metal powder can either be pre-mixed with the epoxy resin or with the curing agent; in this case, the epoxy resin and the curing agent are packed in two separate units to avoid premature curing of the epoxy resin and are only mixed together immediately before use.
- The metal powder can be mixed with a mixture of the epoxy resin and the curing agent; in this case, the die-attach composition is packed in one unit and has to be kept at low temperature before use in order to avoid premature curing of the epoxy resin.
- One part of the epoxy resin can be pre-mixed with a first portion of the metal powder and the second portion of the metal powder is pre-mixed with a mixture of the remaining part of the epoxy resin with the curing agent; in this case, the die-attach composition is again packed in two separate units to avoid premature curing of the epoxy resin and is only mixed together immediately before use.

In order to attach discrete high power semiconductors to printed circuit boards with the die-attach composition of the invention, the composition is applied to the printed circuit board, the semiconductor is placed onto the board and the die-attach composition is then cured at a temperature between 80 and 250 °C, preferably at a temperature between 100 and 150 °C.

When using copper as filler material it is preferred to avoid oxidation of the copper surfaces during storage by coating the copper powder with an oxidation preventing material. The coating material may be a fatty acid, preferably a saturated fatty acid, a polysiloxane or a phosphide compound. The fatty acids can be selected from oleic acid, myristic acid, palmitic acid, margaric acid, stearic acid and arachidic acid. The coating material is applied in an amount of from 0.1 to 1 wt.-% relative to the total weight of the coated copper powder. Most preferred are coating materials with slight hydrophilic properties, i.e. with little polar groups, so as to minimize attraction of water.

For standard die-attach applications the die-attach composition should contain 40 to 90 wt.-% of metal powder relative to the total weight of the composition. For dispensing applications, the composition should contain between 40 and 70 wt.-%, preferably between 40 and 60 wt.-%, of metal for avoiding blockage of the dispensing nozzle. In case of die-attachment by printing, the adhesive composition may contain between 40 and 90 wt.-% of metal powder relative to the total weight of the composition.

The following examples and figures are intended to help in further explaining the present invention. The figures show:
- **Figure 1:**: Test rig for measuring thermal conductivity
- **Figure 2:**: Thermal conductivity in dependence of bond line thickness after curing for die-attach compositions filled with various copper powders with a filling degree of 54 wt.-%.
- **Figure 3:**: Thermal conductivity in dependence of bond line thickness after curing for die-attach compositions filled with various copper powders with a filling degree of 80 wt.-%.

### Example:

Table 1 lists a variety of commercial copper powders which were combined with bisphenol F epoxy resin to form metal filled adhesive resins for temperature cycling tests and thermal conductivity measurements.

All copper powders had spheroidal particles, a purity of more than 99.9 % and a thermal conductivity of more than 350 W/(m K). The copper powders Cu1, Cu2, Cu3, Cu4 and Cu5 comply with the requirements of the present invention whereas the copper powders Cu1C and Cu2C and a commercial "High Thermal Conductivity Silver Filled Epoxy Paste" (Ag) were selected for comparison reasons. Two conventional high lead solder pastes Pb1 (Pb88Sn10Ag2) and Pb2 (Pb92.5Sn5Ag2.5) served as reference materials.

**Table 1: properties of metal powders**

| Material | Cu | Cu2 | Cu3 | Cu4 | Cu5 | Cu1C | Cu2C |
|---|---|---|---|---|---|---|---|
| Purity (without coating) | >99.9 % | >99.9 % | >99.9 % | >99.9 % | >99.9 % | >99.9 % | >99.9 % |
| particle size | | | | | | | |
| D₁₀ [µm] | 0.5 | 0.9 | 1.7 | 0.3 | 7.9 | 0.2 | 3.1 |
| D₅₀ [µm] | 1.5 | 1.5 | 3.6 | 8.3 | 22.1 | 0.6 | 4.5 |
| D₉₀ [µm] | 2.5 | 3.2 | 6.7 | 12.3 | 41.2 | 0.9 | 6.7 |
| particle shape | spheroidal | spheroidal | spheroidal | spheroidal | spheroidal | spheroidal | spheroidal |
| Coating of particle surface | 0.5 wt% fatty acid | 0.5 wt% fatty acid | 0.5 wt% fatty acid | 0.03 wt-% polysiloxane + phosphide | 0.03 wt-% polysiloxane + phosphide | 0.05 wt-% unknown | 0.05 wt-% unknown |
| Degree of surface oxidation | < 10 % | < 10 % | < 10 % | <30% | <30% | >50% | >50% |

### Thermal conductivity measurements:

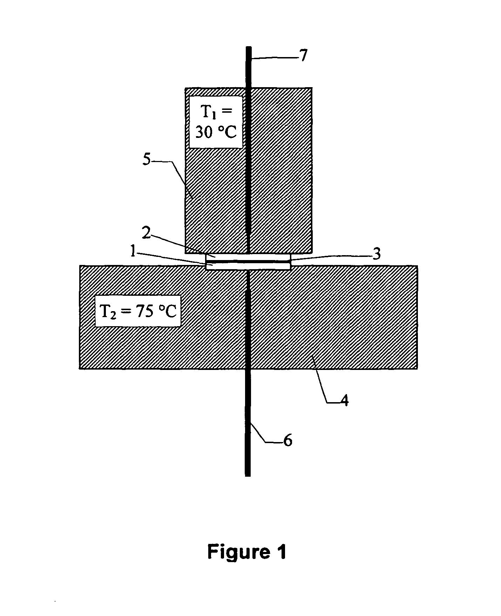

For measurement of thermal conductivity versus bond line thickness a series of silicon chips were attached to copper substrates using bisphenol F filled with different powders according to Table 1. The bond was cured for 5 minutes at 150 °C. The measurements were performed by using the test rig shown in Figure 1. The test pieces were placed with their copper substrates (1) on a copper block (4) heated to T₂ = 75 °C providing a constant temperature. The silicon chips (2) were contacted with another copper block (5) immersed in ambient air (T₁ = 30 °C). The temperatures at the copper and silicon side of the sandwiches were measured with thermocouples (6) and (7). The temperature difference between both sides is proportional to the thermal conductivity of the test pieces consisting of silicon chip (2), bond line (3) and copper substrate (1).

Two set of measurements were performed - one with a filling degree of 54 wt-% for die-attachments by dispensing the die-attach composition and a second set of measurements with a filling degree of 80 wt.-% for die-attachment using printing of the die-attach composition.

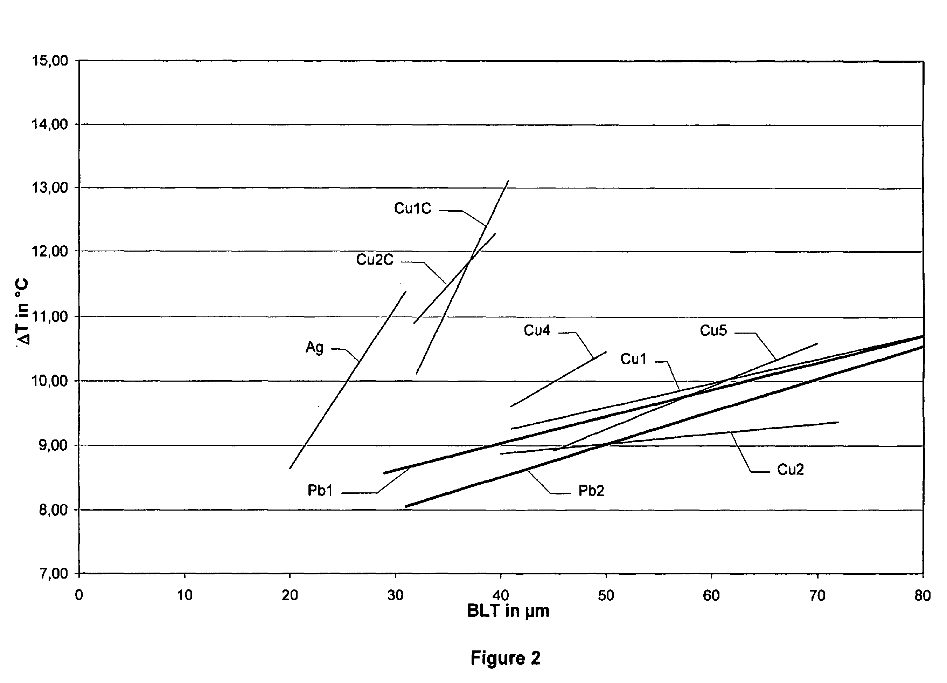

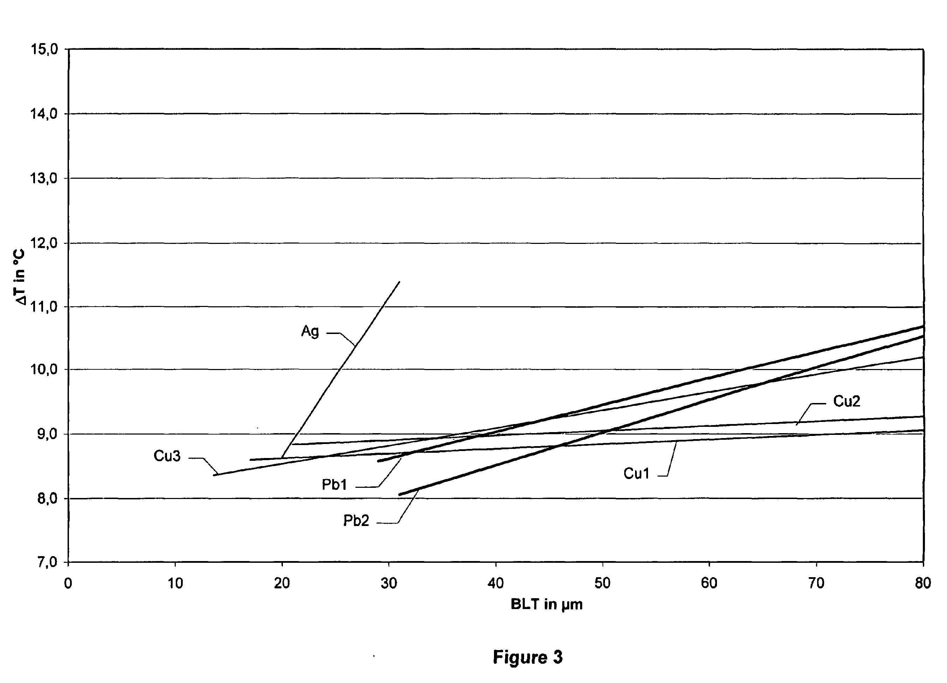

Figures 2 and 3 show the temperature differences measured across the test pieces for different bond line thicknesses (BLT). The heavy lines in both figures show the behavior of the reference samples attached with the commercial solder pastes Pb1 and Pb2. It can clearly be seen that the samples attached with the die-attach compositions according to the invention (Cu1 to Cu5) exhibit a similar thermal conductivity as the reference samples using soldering. Contrary, the comparison samples Ag, Cu1C and Cu2C show a steep increase of the temperature difference with increasing bond line thickness and are thus not acceptable.

### Temperature cycling / Thermal fatigue

For the temperature cycling tests silicon chips of 12 x 12 x 0.5 mm³ were bonded to copper substrates with dimension 12 x 12 x 1 mm³ using the metal filled resins mixed with a curing agent. The bond was cured for 5 minutes at 150 °C and resulted in a bond layer thickness of approximately 50 µm. The comparison die-attach compositions (Ag, Pb1 and Pb2) were processed according to supplier's recommendations.

The test pieces were subjected to 1000 temperature cycles with 15 minutes soak time according to JEDEC Standard test condition "H" (-55 to +150 °C).

The die-attach compositions with metal powders Cu1 to Cu5 exhibited no failures after temperature cycling. These powders had a low concentration of CuO in the surface layer as measured by XPS. Contrary to that, use of copper powders Cu1C and Cu2C with high surface oxidation did not pass the temperature cycling tests. The results are shown in Table 2.

**Table 2: Thermal fatigue results after 1000 cycles (5 samples for each test)**

| Die-attach composition | | Filling degree of adhesive [wt.-%] | Test result |
|---|---|---|---|
| Metal Powder | Resin | | |
| Cu1 | bisphenol F | 54 | pass |
| Cu2 | bisphenol F | 54 | pass |
| Cu4 | bisphenol F | 54 | pass |
| Cu5 | bisphenol F | 54 | pass |
| Cu1C | bisphenol F | 54 | fail |
| Cu2C | bisphenol F | 54 | fail |
| Cu1 | bisphenol F | 80 | pass |
| Cu2 | bisphenol F | 80 | pass |
| Cu3 | bisphenol F | 80 | pass |
| Ag | unknown | 85 | fail |
| Pb1 | Solder paste | 100 | pass |
| Pb2 | Solder paste | 100 | pass |

| | | | |
|---|---|---|---|
| pass: no delamination fail: chip is broken or delamination in the joint | | | |

## Claims

1. Use of a die-attach composition for attaching high-power semiconductor devices to a printed circuit board, wherein the die-attach composition comprises a two component adhesive and a metal powder, wherein one component of the adhesive is an epoxy resin and the second component is a curing agent, and wherein the metal of the metal powder has a thermal conductivity of more than 250 W/(m · K) and comprises copper, and the powder particles have a spheroidal shape.

2. Use according to claim 1, wherein the metal powder has a mean particle diameter D₅₀ between 1 and 50 µm.

3. Use according to claim 2, wherein the metal of the metal powder is copper with a purity of more than 99.5 wt.-%.

4. Use according to claim 2, wherein the metal of the metal powder is copper with a purity of more than 99.9 wt.-%.

5. Use according to claim 3 or 4, wherein less than half of the copper atoms in a surface layer have been oxidized to CuO as measured by XPS

6. Use according to claim 1, wherein the epoxy resin is selected from the group consisting of bisphenol A epoxy resin and bisphenol F epoxy resin.

7. Use according to claim 6, wherein the metal powder is pre-mixed with the epoxy resin or with the curing agent.

8. Use according to claim 7, wherein the metal powder is pre-mixed with both the epoxy resin and the curing agent.

9. Use according to claim 8, wherein one part of the epoxy resin is pre-mixed with a first portion of the metal powder and the second portion of the metal powder is pre-mixed with a mixture of the second part of the epoxy resin with the curing agent.

10. Use according to claim 1, wherein the composition contains 40 to 90 wt.-% of metal powder relative to the total weight of the composition.

11. Use according to claim 1, wherein the metal powder is coated with fatty acid, polysiloxane or with a phosphide compound prior to mixing with the components of the adhesive.

12. Use according to claim 1, wherein the die-attach composition is applied by dispensing and the composition contains 40 to 70 wt.-% of metal powder relative to the total weight of the composition.

13. Use of according to claim 1 wherein the die-attach composition is applied by printing and the composition contains 40 to 90 wt.-% of metal powder relative to the total weight of the composition.

14. Method for attaching discrete high power semiconductors to printed circuit boards by mixing the components of the die-attach composition as specified in one of claims 1 to 11, applying the mixture to the power semiconductor or printed circuit board, placing the semiconductor onto the board and curing the die-attach composition at a temperature between 80 and 250 °C.

15. High power semiconductor device comprising a printed circuit board and attached thereon discrete high power semiconductors, wherein the high power semiconductors are attached to the printed circuit board with a cured die-attach composition as specified in claim 1 forming a bond line between the semiconductor and the printed circuit board with a thickness between 20 and 80 µm.

16. High power semiconductor device according to claim 15, wherein the bond line has a thermal conductivity of more than 40 W/(m · K).

## Patentansprüche

1. Verwendung einer Chipmontagezusammensetzung zum Montieren von Hochleistungshalbleiterbauelementen an einer Leiterplatte, wobei die Chipmontagezusammensetzung einen Zweikomponentenkleber und ein Metallpulver umfaßt, wobei eine Komponente des Klebers ein Epoxidharz ist und die zweite Komponente ein Härtemittel ist und wobei das Metall des Metallpulvers eine Wärmeleitfähigkeit von mehr als 250 W/ (m•K) aufweist und Kupfer umfaßt und die Pulverteilchen eine sphäroidale Gestalt aufweisen.

2. Verwendung nach Anspruch 1, wobei das Metallpulver einen mittleren Teilchendurchmesser D₅₀ zwischen 1 und 50 µm aufweist.

3. Verwendung nach Anspruch 2, wobei das Metall des Metallpulvers Kupfer mit einer Reinheit von über 99,5 Gew.-% ist.

4. Verwendung nach Anspruch 2, wobei das Metall des Metallpulvers Kupfer mit einer Reinheit von über 99,9 Gew.-% ist.

5. Verwendung nach Anspruch 3 oder 4, wobei weniger als die Hälfte der Kupferatome in einer Oberflächenschicht nach Messung durch XPS zu CuO oxidiert worden ist.

6. Verwendung nach Anspruch 1, wobei das Epoxidharz ausgewählt ist aus der Gruppe bestehend aus Bisphenol-A-Epoxidharz und Bisphenol-F-Epoxidharz.

7. Verwendung nach Anspruch 6, wobei das Metallpulver mit dem Epoxidharz oder mit dem Härtemittel vorgemischt ist.

8. Verwendung nach Anspruch 7, wobei das Metallpulver sowohl mit dem Epoxidharz als auch dem Härtemittel vorgemischt ist.

9. Verwendung nach Anspruch 8, wobei ein Teil des Epoxidharzes mit einem ersten Teil des Metallpulvers vorgemischt ist und der zweite Teil des Metallpulvers mit einer Mischung aus dem zweiten Teil des Epoxidharzes mit dem Härtemittel vorgemischt ist.

10. Verwendung nach Anspruch 1, wobei die Zusammensetzung 40 bis 90 Gew.-% Metallpulver relativ zum Gesamtgewicht der Zusammensetzung enthält.

11. Verwendung nach Anspruch 1, wobei das Metallpulver mit Fettsäure, Polysiloxan oder mit einer Phosphid-Verbindung vor dem Mischen mit den Komponenten des Klebers beschichtet wird.

12. Verwendung nach Anspruch 1, wobei die Chipmontagezusammensetzung durch Dispensierung aufgebracht wird und die Zusammensetzung 40 bis 70 Gew.-% Metallpulver relativ zum Gesamtgewicht der Zusammensetzung enthält.

13. Verwendung nach Anspruch 1, wobei die Chipmontagezusammensetzung durch Drucken aufgebracht wird und die Zusammensetzung 40 bis 90 Gew.-% Metallpulver relativ zum Gesamtgewicht der Zusammensetzung enthält.

14. Verfahren zum Montieren diskreter Hochleistungshalbleiter an Leiterplatten durch Mischen der Komponenten der Chipmontagezusammensetzung wie in einem der Ansprüche 1 bis 11 spezifiziert, Aufbringen der Mischung auf den Leistungshalbleiter oder die Leiterplatte, Plazieren des Halbleiters auf der Platine und Härten der Chipmontagezusammensetzung bei einer Temperatur zwischen 80 und 250°C.

15. Hochleistungshalbleiterbauelement umfassend eine Leiterplatte und daran montiert diskrete Hochleistungshalbleiter, wobei die Hochleistungshalbleiter mit einer gehärteten Chipmontagezusammensetzung wie in Anspruch 1 spezifiziert an der Leiterplatte angebracht werden, wodurch eine Kleberschicht zwischen dem Halbleiter und der Leiterplatte mit einer Dicke zwischen 20 und 80 µm entsteht.

16. Hochleistungshalbleiterbauelement nach Anspruch 15, wobei die Kleberschicht eine Wärmeleitfähigkeit von über 40 W/(m·K) aufweist.

## Revendications

1. Utilisation d'une composition de fixation de pastilles pour la fixation de dispositifs semi-conducteurs haute puissance à une carte à circuit imprimé, dans laquelle la composition de fixation de pastilles comprend un adhésif à deux composants et une poudre métallique, dans laquelle un composant de l'adhésif est une résine époxyde et le deuxième composant est un agent de durcissement, et dans laquelle le métal de la poudre métallique a une conductivité thermique supérieure à 250 W/(m·K) et comprend du cuivre, et les particules de poudre ont une forme sphéroïdale.

2. Utilisation selon la revendication 1, dans laquelle la poudre métallique a un diamètre moyen de particule D₅₀ de 1 à 50 µm.

3. Utilisation selon la revendication 2, dans laquelle le métal de la poudre métallique est du cuivre ayant une pureté supérieure à 99,5 % en poids.

4. Utilisation selon la revendication 2, dans laquelle le métal de la poudre métallique est du cuivre ayant une pureté supérieure à 99,9 % en poids.

5. Utilisation selon la revendication 3 ou 4, dans laquelle moins de la moitié des atomes de cuivre dans une couche de surface ont été oxydés en produisant du CuO, cette caractéristique étant mesurée par XPS.

6. Utilisation selon la revendication 1, dans laquelle la résine époxyde est sélectionnée dans le groupe constitué de la résine époxyde de bisphénol A et de la résine époxyde de bisphénol F.

7. Utilisation selon la revendication 6, dans laquelle la poudre métallique est prémélangée avec la résine époxyde ou avec l'agent de durcissement.

8. Utilisation selon la revendication 7, dans laquelle la poudre métallique est prémélangée avec la résine époxyde ainsi qu'avec l'agent de durcissement.

9. Utilisation selon la revendication 8, dans laquelle une partie de la résine époxyde est prémélangée avec une première portion de la poudre métallique et la deuxième portion de la poudre métallique est prémélangée avec un mélange de la deuxième partie de la résine époxyde avec l'agent de durcissement.

10. Utilisation selon la revendication 1, dans laquelle la composition contient de 40 à 90 % en poids de poudre métallique relativement au poids total de la composition.

11. Utilisation selon la revendication 1, dans laquelle la poudre métallique est enrobée d'un acide gras, d'un polysiloxane, ou d'un composé phosphure avant le mélange avec les composants de l'adhésif.

12. Utilisation selon la revendication 1, dans laquelle la composition de fixation de pastilles est appliquée par distribution et la composition contient de 40 à 70 % en poids de poudre métallique relativement au poids total de la composition.

13. Utilisation selon la revendication 1, dans laquelle la composition de fixation de pastilles est appliquée par impression et la composition contient de 40 à 90 % en poids de poudre métallique relativement au poids total de la composition.

14. Méthode de fixation de semi-conducteurs haute puissance discontinus à des cartes à circuits imprimés par mélange des composants de la composition de fixation de pastilles comme il est indiqué dans l'une des revendications 1 à 11, application du mélange sur le semi-conducteur de puissance ou la carte à circuit imprimé, positionnement du semi-conducteur sur le carte, et durcissement de la composition de fixation de pastilles à une température de 80 à 250 °C.

15. Dispositif semi-conducteur haute puissance comprenant une carte à circuit imprimé et, fixés dessus, des semi-conducteurs haute puissance discontinus, dans lequel les semi-conducteurs haute puissance sont fixés à la carte à circuit imprimé avec une composition de fixation de pastilles durcie selon la revendication 1, en formant entre le semi-conducteur et la carte à circuit imprimé un plan de joint ayant une épaisseur de 20 à 80 µm.

16. Dispositif semi-conducteur haute puissance selon la revendication 15, dans lequel le plan de joint a une conductivité thermique supérieure à 40 W/ (m·K).
